# EUROPEAN PATENT APPLICATION

(11) **EP 4 614 331 A1**
(43) Date of publication of application: **10.09.2025**
(21) Application number: 25161520.9
(22) Date of filing: 04.03.2025
(51) Int. Cl.: G06F 11/10

(54) **MEMORY CONTROLLER, MEMORY MODULE AND MEMORY SYSTEM**

(30) Priority: 05.03.2024 KR 20240031613; 23.04.2024 KR 20240054152; 14.11.2024 KR 20240162503
(71) Applicant: Samsung Electronics Co., Ltd., Suwon-si, Gyeonggi-do 16677 (KR)
(72) Inventor: SHIN, Hoon, 16677 Suwon-si, Gyeonggi-do (KR); AHN, Sunggi, 16677 Suwon-si, Gyeonggi-do (KR); KIM, Sung-Rae, 16677 Suwon-si, Gyeonggi-do (KR); KIM, Wijong, 16677 Suwon-si, Gyeonggi-do (KR); RYU, Yesin, 16677 Suwon-si, Gyeonggi-do (KR)
(74) Representative: Kuhnen & Wacker Patent- und Rechtsanwaltsbüro PartG mbB

(57) **Abstract**

A memory system (20) is provided. The memory system (20) includes: first memory devices (200d_1-200d_n); a second memory device (200p); and a memory controller configured to control the plurality of first memory devices (200d_1-200d_n) and the second memory device (200p). Each of the first memory devices (200d_1-200d_n) is configured to store a first data set (Data) including a first set of data bits in different bit positions, each of the bit positions corresponding to a burst order and a DQ. The second memory device (200p) is configured to store a second data set (Parity) including parity bits for a plurality of first data sets (Data), respectively stored in the plurality of first memory devices (200d_1-200d_n). A second set of data bits corresponding to a first parity bit of the parity bits are included in the plurality of first data sets (Data), respectively, and at least two data bits of the second set of data bits have different bit positions.

## Description

### BACKGROUND

The present disclosure relates to a memory controller, a memory module, and a memory system.

Memory devices are used to store data and may be categorized into volatile memory devices and nonvolatile memory devices. Volatile memory devices lose their stored data when their power supplies are interrupted. A dynamic random access memory (DRAM) is a type of volatile memory that is may be used in a variety of applications such as mobile systems, servers, or graphics devices.

A plurality of memory devices may be mounted on a single substrate and provided in the form of a memory module to achieve higher performance and higher capacity. A portion of the memory devices mounted on a memory module may store parity data to correct errors occurring in data stored in other memory devices.

### SUMMARY

One or more example embodiments provide a memory system performing an error correction operation with improved performance.

According to an aspect of an example embodiment, a memory system includes: a plurality of first memory devices; a second memory device; and a memory controller configured to control the plurality of first memory devices and the second memory device. Each of the plurality of first memory devices is configured to store a first data set including a first set of data bits in different bit positions, each of the bit positions corresponding to a burst order and a DQ. The second memory device is configured to store a second data set including parity bits for a plurality of first data sets, respectively stored in the plurality of first memory devices. A second set of data bits corresponding to a first parity bit of the parity bits are included in the plurality of first data sets, respectively, and at least two data bits of the second set of data bits have different bit positions.

According to another aspect of an example embodiment, a memory module includes: a plurality of first memory devices; and a second memory device. Each of the plurality of first memory devices is configured to store a first data set including a first set of data bits having bit positions, each of the bit positions corresponding to a burst order and a DQ. The second memory device is configured to store a second data set including first parity bits for a plurality of first data sets, respectively stored in the plurality of first memory devices. A second set of data bits corresponding to one parity bit of the first parity bits are included in the plurality of first data sets, respectively, and at least two data bits of the second set of data bits have different bit positions.

According to another aspect of an example embodiment, a method of operating a memory controller to control a memory module including a plurality of first memory devices and a second memory device, is provided. The method includes: storing a plurality of first data sets in the plurality of first memory devices, respectively; and storing a second data set, including parity bits for the plurality of first data sets, in the second memory device. Each of the plurality of first data sets includes a first set of data bits having bit positions, each of the bit positions corresponding to a burst order and a DQ. A second set of data bits corresponding to a first parity bit of the parity bits are included in the plurality of first data sets, respectively, and bit positions of at least two data bits of the second set of data bits are different from each other.

### BRIEF DESCRIPTION OF DRAWINGS

The above and other aspects and features of the present disclosure will be more clearly understood from the following description of example embodiments, taken in conjunction with the accompanying drawings, in which
FIG. 1 is a block diagram of an electronic system according to an example embodiment;
FIGS. 2A is a diagrams illustrating bit positions of bits included in a data set according to an example embodiment;
FIG. 2B is a diagram illustrating related parity mapping;
FIG. 2C is a diagram illustrating parity mapping according to an example embodiment;
FIG. 3 is a diagram illustrating a bank according to an example embodiment;
FIG. 4 is a block diagram of a memory device according to an example embodiment;
FIG. 5 is a block diagram of a memory controller according to an example embodiment;
FIG. 6 is a flowchart illustrating a method of operating a memory system according to an example embodiment;
FIGS. 7A and 7B are diagrams illustrating a method of operating a memory system according to an example embodiment;
FIG. 8 is a flowchart illustrating a method of operating a memory system according to an example embodiment;
FIGS. 9A, 9B, 9C and 9D are diagrams illustrating a method of operating a memory system according to an example embodiment;
FIGS. 10A and 10B are diagrams illustrating limitations of an error correction operation during related parity mapping;
FIGS. 11A, 11B, 11C and 11D are diagrams illustrating a method of operating a memory system according to an example embodiment; and
FIG. 12 is a block diagram of an electronic system according to an example embodiment.

### DETAILED DESCRIPTION

Hereinafter, example embodiments will be described with reference to the accompanying drawings.

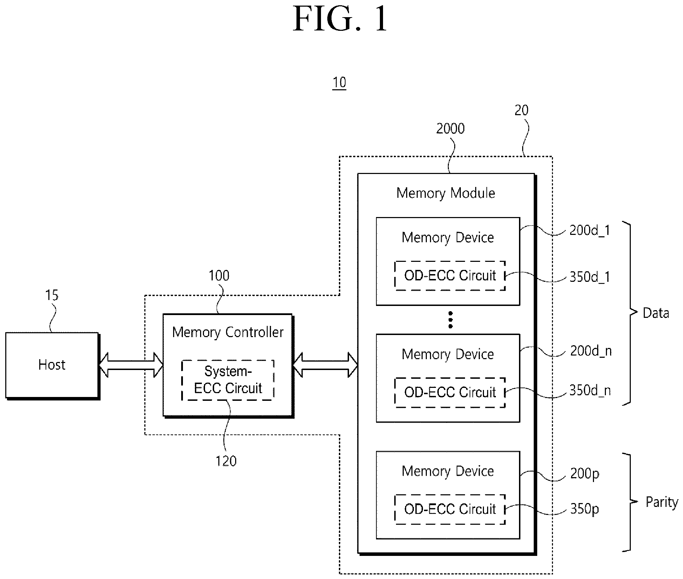

FIG. 1 is a block diagram illustrating the configuration of an electronic system according to an example embodiment.

Referring to FIG. 1, an electronic system 10 may include a host 15 and a memory system 20. The memory system 20 may include a memory controller 100 and a memory module 2000. The memory module 2000 may include a plurality of memory devices 200p and 200d_1 to 200d_n. The plurality of memory devices 200p and 200d_1 to 200d_n may include a plurality of data memory devices 200d_1 to 200d_n and a single parity memory device 200p.

Each of the plurality of memory devices 200p and 200d_1 to 200d_n may input or output bits in units of prefetch sizes. Hereinafter, a set of bits stored in a memory device through a single write operation or output from a memory device through a single read operation, corresponding to a prefetch size, is referred to as a "data set."

The prefetch size is determined depending on the number of DQs (i.e., the data bus width or the number of data pins) used by each memory device and a burst length, so that bits included in a data set may have bit positions defined by a burst order and DQs.

According to example embodiments, each of the plurality of data memory devices 200d_1 to 200d_n may store a first data set including data bits. The parity memory device 200p may store a second data set including parity bits for a plurality of first data sets, respectively stored in the plurality of data memory devices 200d_1 to 200d_n.

Data bits corresponding to one of the parity bits included in the second data set are included in different first data sets and may have different bit positions.

As described above, parity bits mapped to data bits having different bit positions in each of the first data sets may be stored in the parity memory device 200p, allowing the memory system 20 to perform an error correction operation with improved performance.

A detailed description will now be provided with reference to FIG. 1. The host 15 may communicate with the memory system 20 using an interface protocol such as peripheral component interconnect-express (PCI-E), advanced technology attachment (ATA), serial ATA (SATA), parallel ATA (PATA), or a serial attached SCSI (SAS). The interface protocols between the host 15 and the memory system 20 are not limited to the above-mentioned examples and may be one of other interface protocols such as a universal serial bus (USB) protocol, an MMC protocol, an enhanced small disk interface (ESDI) protocol, or an integrated drive electronics (IDE) protocol.

The memory controller 100 may control the overall operation of the memory system 20. The memory controller 100 may control the overall data exchange between the host 15 and the memory module 2000. For example, the memory controller 100 may control the memory devices 200p and 200d_1 to 200d_n to write or read data in response to a request from the host 15. Also, the memory controller 100 may control the operation of the memory devices 200p and 200d_1 to 200d_n by applying commands and/or addresses to control the memory devices 200p and 200d_1 to 200d_n.

According to an example embodiment, the memory controller 100 may control the plurality of first data sets to be stored in the plurality of data memory devices 200d_1 to 200d_n, respectively. Also, the memory controller 100 may control the second data set to be set (i.e., stored) in the parity memory device 200p. Each of the parity bits included in the second data set may have a value based on an XOR operation on corresponding data bits. For example, each of the parity bits may be even XOR parity, but example embodiments are not limited thereto. In some example embodiments, each of the parity bits may be odd XOR parity.

The memory controller 100 may receive the plurality of first data sets and the second data set from the plurality of data memory devices 200d_1 to 200d_n and the parity memory device 200p, and may perform an error correction operation on the received data sets.

For example, when data is requested by the host 15, the memory controller 100 may apply a read command to the plurality of data memory devices 200d_1 to 200d_n and the parity memory device 200p to receive the plurality of first data sets and the second data set. Accordingly, the memory controller 100 may perform a parity check on the plurality of first data sets and the second data set to determine candidate error bit positions for each of the plurality of first data sets and the second data set.

The memory controller 100 may obtain first flags corresponding to each of the plurality of first data sets and the second data set. Each of the first flags may indicate a result of the error correction operation performed on each of the memory devices 200p and 200d_1 to 200d_n. For example, the first flags may include results of a plurality of error correction operations, each performed on the plurality of first data sets in the plurality of data memory devices 200d_1 to 200d_n. Also, the first flags may include a result of the error correction operation performed on the second data set in the parity memory device 200p. Accordingly, the memory controller 100 may determine an error data set including error bits, among the plurality of first data sets and the second data set, based on the received first flags.

According to an example embodiment, the memory controller 100 may determine an error data set when the first flags have specific values. Even when the first flags do not have the specific values, the memory controller 100 may perform an iteration operation to again determine an error data set, which will be described later. Accordingly, there may be an increased likelihood of detecting an error data set. As described above, this is because parity bits are mapped to data bits having different bit positions in each of the first data sets and are stored in the parity memory device 200p.

Accordingly, the memory controller 100 may flip bits corresponding to candidate error bit positions, among bits included in an error data set, to perform an error correction operation.

According to an example embodiment, the memory controller 100 may include a system error correction code (ECC) circuit 120. The system ECC circuit 120 may perform operations related to an error correction operation, among the operations of the memory controller 100. For example, the system ECC circuit 120 may perform an operation of mapping data bits and parity bits by varying bit positions, an operation of performing a parity check to determine candidate error bit positions, an operation of determining an error data set based on flags, and an operation of flipping bits corresponding to candidate error bit positions among the bits included in the error data set, but example embodiments are not limited thereto.

Each of the plurality of memory devices 200p and 200d_1 to 200d_n may receive a data set from the memory controller 100 and store the received data set. Also, each of the plurality of memory devices 200p and 200d_1 to 200d_n may read the stored data set in response to a request from the memory controller 100 and transmit the read data set to the memory controller 100.

According to an example embodiment, the memory module 2000 may be a dual in-line memory module (DIMM). For example, the memory module 2000 may be a registered DIMM (RDIMM), a load reduced DIMM (LRDIMM), an unbuffered DIMM (UDIMM), a fully buffered DIMM (FB-DIMM), or a small outline DIMM (SO-DIMM). However, example embodiments are not limited thereto and the memory module 2000 may also be another memory module, such as a single in-line memory module (SIMM).

According to an example embodiment, each of the plurality of memory devices 200p and 200d_1 to 200d_n may be a memory device including volatile memory cells. For example, the memory device 200 may be various dynamic random access memory (DRAM) devices such as a double data rate synchronous DRAM (DDR SDRAM) device, a DDR2 SDRAM device, a DDR3 SDRAM device, a DDR4 SDRAM device, a DDR5 SDRAM device, a DDR6 SDRAM device, a low power double data rate (LPDDR) SDRAM device, an LPDDR2 SDRAM device, an LPDDR3 SDRAM device, an LPDDR4 SDRAM device, an LPDDR4X SDRAM device, an LPDDR5 SDRAM device, a graphics double data rate synchronous graphics random access memory (GDDR SGRAM) device, a GDDR2 SGRAM device, a GDDR3 SGRAM device, a GDDR4 SGRAM device, a GDDR5 SGRAM device, or a GDDR6 SGRAM device.

According to an example embodiment, each of the plurality of memory devices 200p and 200d_1 to 200d_n may be a memory device in which DRAM dies are stacked, such as a high bandwidth memory (HBM), an HBM2, or an HBM3.

According to an example embodiment, each of the plurality of memory devices 200p and 200d_1 to 200d_n may be an SRAM device, a NAND flash memory device, a NOR flash memory device, an RRAM device, an FRAM device, a PRAM device, a TRAM device, or an MRAM device.

According to an example embodiment, the plurality of data memory devices 200d_1 to 200d_n may provide data corresponding to a cache line size. Therefore, the number of the plurality of data memory devices 200d_1 to 200d_n may be determined depending on a prefetch size of each of the plurality of data memory devices 200d_1 to 200d_n. For example, when the cache line size is 64 bytes (= 512 bits) and the prefetch size of each of the plurality of data memory devices 200d_1 to 200d_n is 128 bits, the number of the plurality of data memory devices 200d_1 to 200d_n may be four. When the cache line size is 64 bytes (= 512 bits) and the prefetch size of each of the plurality of data memory devices 200d_1 to 200d_n is 256 bits, the number of the plurality of data memory devices 200d_1 to 200d_n may be two.

According to an example embodiment, the plurality of memory devices 200p and 200d_1 to 200d_n may include on-die ECC circuits 350p and 350d_1 to 350d_n, respectively, generating the above-mentioned first flag. For example, each of the on-die ECC circuits 350p and 350d_1 to 350d_n may perform an error correction operation on a data set input or output through the corresponding memory device using a parity check matrix (or H-matrix) and generate a first flag regarding a result of the error correction operation. The first flag may indicate a non-uncorrectable error (non-UE) when it is determined that there is no error or that the error has been corrected, or an uncorrectable error (UE) when it is determined that an uncorrectable error has occurred. The generated first flag may be provided to the memory controller 100 based on a request of the memory controller 100.

According to an example embodiment, each of the plurality of data memory devices 200d_1 to 200d_n may be referred to as a data chip. In addition, the parity memory device 200p may be referred to as a module ECC chip, a system ECC chip, or the like, but example embodiments are not limited thereto.

As described above, the memory system 20 according to one or more example embodiments may perform an error correction operation with improved performance.

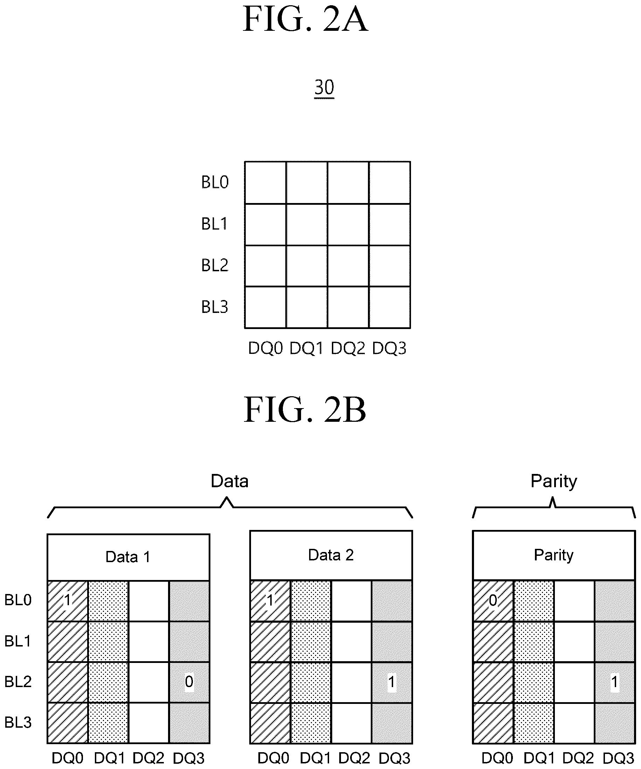

FIGS. 2A is a diagrams illustrating bit positions of bits included in a data set according to an example embodiment. In FIG. 2A, for ease of description, an example is provided in which a prefetch size of a data set is 16 bits.

As illustrated in FIG. 2A, a memory device using a data set 30 has a burst length (BL) of 4 and uses four DQs. The data set may include 16 bits, respectively corresponding to 16 bit positions defined by a burst order BL0, BL1, BL2, and BL3 and DQs DQ0, DQ1, DQ2, and DQ3.

Similarly, bits included in a data set having another prefetch size may also have bit positions defined by the burst order and DQs.

FIG. 2B is a diagram illustrating related parity mapping. FIG. 2B illustrates first data sets Data 1 and Data 2 stored in two data memory devices having a prefetch size of 16 bits and a second data set parity stored in a parity memory device.

Referring to FIG. 2B, in the case of related technology, a parity bit for data bits having the same bit position in the first data set Data 1 and another first data set Data 2 may be stored at the same bit position in the second data set Parity.

For example, a parity bit "0" for data bits "11" having bit positions BL0 and DQ0 in Data 1 and Data 2 may be stored at the bit positions BL0 and DQ0 in the parity. Also, for example, a parity bit "1" for data bits "01" having bit position BL2 and DQ3 in Data 1 and Data 2 may be stored at bit positions BL2 and DQ3 in the parity. This is equally applied to the remaining data bits and parity bits.

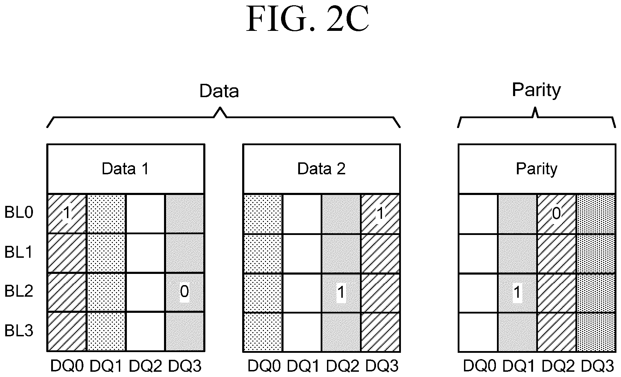

FIG. 2C is a diagram illustrating parity mapping according to an example embodiment. FIG. 2C illustrates first data sets Data 1 and Data 2 stored in two data memory devices having a prefetch size of 16 bits and a second data set Parity stored in a parity memory device.

According to an example embodiment, at least two data bits among data bits corresponding to one of the parity bits included in the second data set Parity may have different bit positions within corresponding at least two first data sets, respectively.

Referring to FIG. 2C, a parity bit "0" for a data bit "1" having bit positions BL0 and DQ0 in Data 1 and a data bit "1" having bit positions BL0 and DQ3 in Data 2 may be stored at the bit positions BL0 and DQ2 in the parity. Also, for example, a parity bit "1" for a data bit "0" having bit positions BL2 and DQ3 in Data 1 and a data bit "1" having bit positions BL2 and DQ2 in Data 2 may be stored at the bit position BL2 and DQ1 in the parity. As described above, according to an example embodiment, each data bit and a corresponding parity bit may be mapped to have different DQ positions. As illustrated in FIG. 2C, DQ0 of Data 1, DQ3 of Data 2, and DQ2 in the parity are mapped to each other, DQ1 of Data 1, DQ0 of Data 2, and DQ3 in the parity are mapped to each other, DQ2 of Data 1, DQ1 of Data 2, and DQ0 in the parity are mapped to each other, and DQ3 of Data 1, DQ2 of Data 2, and DQ1 in the parity are mapped to each other.

However, example embodiments are not limited thereto, and each data bit and a corresponding parity bit may be mapped to have different BL positions, or each data bit and a corresponding parity bit may be mapped to have different BL positions and different DQ positions.

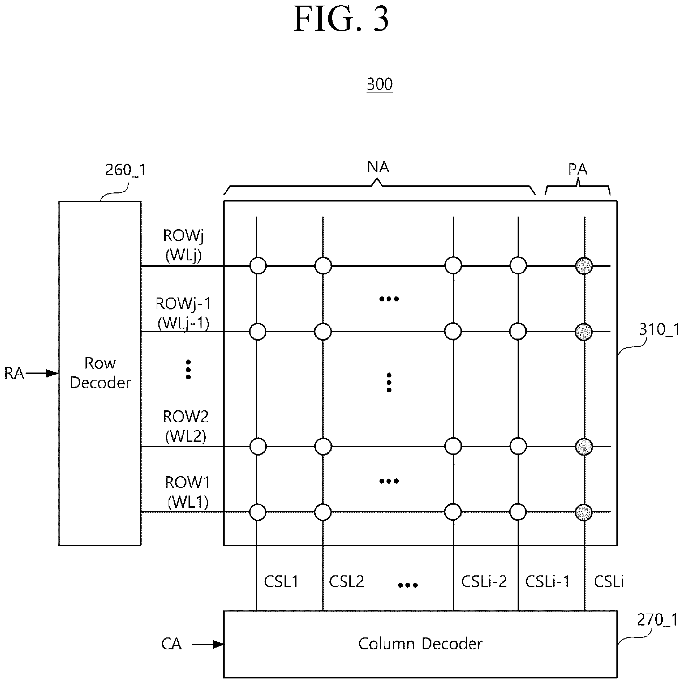

FIG. 3 is a diagram illustrating a bank according to an example embodiment. A bank 300 of FIG. 3 may be one of the plurality of banks included in each of the plurality of memory devices 200p and 200d_1 to 200d_n of FIG. 1.

Referring to FIG. 3, the bank 300 may include a bank array 310_1, a row decoder 260_1, and a column decoder 270_1. The bank array 310_1 may include a plurality of memory cells. The plurality of memory cells may be electrically connected to a plurality of wordlines WL1 to WLj and a plurality of column select lines CSL1 to CSLi.

The bank array 310_1 may include a normal cell area NA, in which a data set is stored, and a parity cell area PA in which a parity bit for the data set stored in the normal cell area NA is stored.

The row decoder 260_1 may activate one of the plurality of rows ROW1 to ROWj in response to a row address RA. For example, the plurality of rows ROW1 to ROWj may correspond to the plurality of wordlines WL1 to WLj, respectively.

The column decoder 270_1 may activate one of the plurality of column select lines CSL1 to COLi in response to a column address CA.

For example, when the bank 300 is included in data memory devices 200d_1 to 200d_n, the first data set including data bits may be stored in the normal cell area NA, and the parity bit for the first data set may be stored in the parity cell area PA.

When the bank 300 is included in the parity memory device 200p, a second data set including parity bits for the plurality of first data sets, respectively stored in the plurality of data memory devices 200d_1 to 200d_n, may be stored in the normal cell area NA, and parity bits for the second data set may be stored in the parity cell area PA.

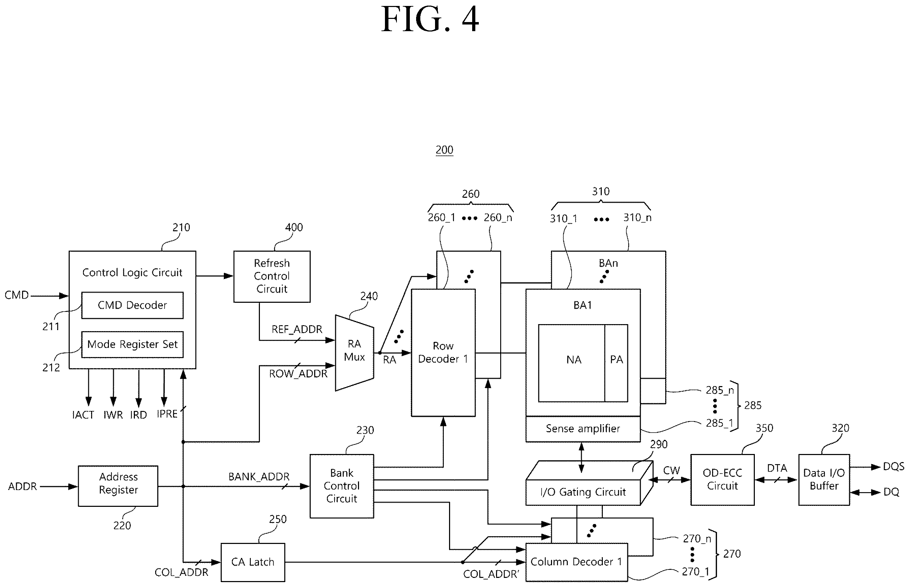

FIG. 4 is a block diagram of a memory device according to an example embodiment. A memory device 200 of FIG. 4 may correspond to one of the plurality of memory devices 200p and 200d_1 to 200d_n of FIG. 1.

Referring to FIG. 4, the memory device 200 may include a control logic circuit 210, an address register 220, a bank control circuit 230, a refresh control circuit 400, a row address multiplexer 240, a column address latch 250, a row decoder group 260, a column decoder group 270, a memory cell array 310, a sense amplifier group 285, an input/output gating circuit 290, an on-die ECC circuit 350, and a data input/output buffer 320.

The memory cell array 310 may include a plurality of bank arrays 310_1 to 310_n. Each of the plurality of bank arrays 310_1 to 310_n may include a plurality of memory cells. For example, each of the plurality of memory cells may be formed at an intersection of a corresponding wordline and a corresponding bitline. Each of the plurality of bank arrays 310_1 to 310_n may correspond to the bank array 310_1 of FIG. 3, but example embodiments are not limited thereto.

The row decoder group 260 may include a plurality of row decoders 260_1 to 260_n. Each of the plurality of row decoders 260_1 to 260_n may be connected to a corresponding bank array among the plurality of bank arrays 310_1 to 310_n.

The sense amplifier group 285 may include a plurality of sense amplifiers 285_1 to 285_n. Each of the plurality of sense amplifiers 285_1 to 285_n may be connected to a corresponding bank array among the plurality of bank arrays 310_1 to 310_n.

The column decoder group 270 may include a plurality of column decoders 270_1 to 270_n. Each of the plurality of column decoders 270_1 to 270_n may be connected to a corresponding bank array of the plurality of bank arrays 310_1 to 310_n through column select lines.

The address register 220 may receive an address ADDR including a bank address BANK_ADDR, a row address ROW_ADDR, and a column address COL_ADDR from the memory controller 100. The address register 220 may provide the received bank address BANK_ADDR to the bank control circuit 230, the received row address ROW_ADDR to the row address multiplexer 240, and the received column address COL_ADDR to the column address latch 250.

The bank control circuit 230 may generate bank control signals in response to the bank address BANK_ADDR. For example, the row decoder corresponding to a bank address BANK_ADDR, among the plurality of row decoders 260_1 to 260_n, may be activated in response to the bank control signals. The column decoder corresponding to a bank address BANK _ADDR, among the plurality of column decoders 270_1 to 270_n, may be activated in response to the bank control signals.

The row address multiplexer 240 may receive a row address ROW_ADDR from the address register 220 and a refresh row address REF_ADDR from the refresh control circuit 400. The row address multiplexer 240 may selectively output the row address ROW_ADDR or the refresh row address REF_ADDR as a row address RA. The row address RA, output from the row address multiplexer 240, may be applied to each of the plurality of row decoders 260_1 to 260_n.

The refresh control circuit 400 may sequentially increment or decrement the refresh row address REF_ADDR in response to refresh signals from the control logic circuit 210 in a normal refresh mode.

The refresh control circuit 400 may receive a hammer address HADDR in a hammer refresh mode. The refresh control circuit 400 may output addresses of wordlines adjacent to an intensively accessed wordline as the refresh row address REF_ADDR based on the hammer address HADDR.

A row decoder selected by the bank control circuit 230, among the plurality of row decoders 260_1 to 260_n, may activate a wordline corresponding to a row address RA output from the row address multiplexer 240. For example, the selected row decoder may apply a wordline driving voltage to a wordline corresponding to a row address.

The column address latch 250 may receive a column address COL_ADDR from the address register 220 and temporarily store the received column address COL_ADDR.

According to an example embodiment, the memory device 200 may perform a burst operation in burst mode. The burst operation may refer to an operation of writing or reading a large amount of data by sequentially decrementing or incrementing the address from an initial address received by the memory device 200 from the memory controller 100. A basic unit of such a burst operation may be a burst length. For example, the burst length may be the number of times data is continuously read or written by decrementing or incrementing the address from the initial address. In an example embodiment, when the burst length is 8, the memory device 200 may perform a burst read operation or a burst write operation 8 times consecutively from the initial address in response to a clock signal CLK.

For example, the column address latch 250 may increment the received column address COL_ADDR in burst mode. The column address latch 250 may apply a temporarily stored or incremented column address COL_ADDR' to each of the plurality of column decoders 270_1 to 270_n.

A column decoder activated by the bank control circuit 230, among the plurality of column decoders 270_1 to 270_n, may activate a sense amplifier corresponding to the bank address BANK_ADDR and column address COL_ADDR through the input/output gating circuit 290.

The input/output gating circuit 290 may include circuits for gating input/output data. Also, the input/output gating circuit 290 may include data latches for storing codewords output from the plurality of bank arrays 310_1 to 310_n and write drivers for writing data in the plurality of bank arrays 310_1 to 310_n.

In an example embodiment, during a read operation, a codeword CW read from a selected bank array, among the plurality of bank arrays 310_1 to 310_n, may be detected by a sense amplifier corresponding to the selected bank array and stored in the data latches of the input/output gating circuit 290. Also, the codeword CW stored in the data latches may be subjected to ECC decoding by the on-die ECC circuit 350 to be provided as data DTA to the data input/output buffer 320. The data input/output buffer 320 may generate a data signal DQ based on data DTA and provide the data signal DQ to the memory controller 100 together with a strobe signal DQS.

In an example embodiment, data DTA to be written in a selected bank array, among the plurality of bank arrays 310_1 to 310_n, may be received as a data signal DQ by the data input/output buffer 320 during a write operation. The data input/output buffer 320 may convert the data signal DQ into data DTA and provide the data DTA to the on-die ECC circuit 350. The on-die ECC circuit 350 may generate parity bits or parity data based on the data DTA and provide a codeword CW, including the data DTA and the parity bits, to the input/output gating circuit 290. The input/output gating circuit 290 may write the codeword CW in the normal cell area NA and the parity cell area PA of the selected bank array.

The data input/output buffer 320 may convert a data signal DQ into data DTA and provide the data DTA to the on-die ECC circuit 350 during a write operation. The data input/output buffer 320 may convert the data DTA, provided from the on-die ECC circuit 350, into a data signal DQ during a read operation.

The on-die ECC circuit 350 may perform ECC encoding on the data DTA during a write operation. The on-die ECC circuit 350 may perform ECC decoding on the codeword CW during a read operation.

According to an example embodiment, the on-die ECC circuit 350 may perform an error correction operation on a data set input or output through the memory device 200 based on the codeword CW and the parity check matrix (or H-matrix) during a read operation, and may generate a first flag regarding a result of performing the error correction operation. The first flag may indicate non-uncorrectable error (non-UE) or uncorrectable error (UE). The non-UE indicates there is no error in the data set or that there was an error but the error has been corrected, and the UE indicates an uncorrectable error has occurred in the data set.

In an example embodiment, the on-die ECC circuits 350 included in each of the plurality of memory devices 200p and 200d_1 to 200d_n may be corresponding devices. For example, the on-die ECC circuit 350 provided in each of the plurality of memory devices 200p and 200d_1 to 200d_n may be the same model or product.

The control logic circuit 210 may control the operation of the memory device 200. For example, the control logic circuit 210 may generate control signals such that the memory device 200 performs a write operation, a read operation, a normal refresh operation, and a hammer refresh operation. The control logic circuit 210 may include a command decoder 211, decoding a command CMD received from the memory controller 100, and a mode register set (MRS) 212 setting an operation mode of the memory device 200.

The command decoder 211 may decode the command CMD to generate internal command signals such as an internal active signal IACT, an internal precharge signal IPRE, an internal read signal IRD, and an internal write signal IWR. Also, the command decoder 211 may decode a chip select signal and a command/address signal to generate control signals corresponding to the command CMD.

According to an example embodiment, a new read command (hereinafter, referred to as, for example, a read retry command) may be defined to request the first flag generated by the on-die ECC circuit 350 together with a data set. When a read retry command is received from the memory controller 100, the command decoder 211 may decode the read retry command and control the operation of the memory device 200 to provide the first flag along with the data set.

The mode register set 212 may set the operation mode of the memory device 200. According to an example embodiment, the mode register set 212 may include a mode register setting the operation mode of the memory device 200 to a first mode or a second mode. The first mode may be a mode in which the memory device 200 operates to provide only a data set in response to a normal read command, and the second mode may be a mode in which the memory device 200 operates to provide the first flag generated by the on-die ECC circuit 350 together with the data set in response to a normal read command.

For example, when a first value is set in the mode register, the memory device 200 may operate in the first mode. Also, when a second value different from the first value is set in the mode register, the memory device 200 may operate in the second mode. The memory controller 100 may change a set value of the mode register through, for example, a mode register write (MRW) command to change the operation mode of the memory device 200.

According to an example embodiment, the memory device 200 may include a pin allocated to output the first flag regarding a result of the error correction operation performed by the on-die ECC circuit 350. The memory device 200 may apply a signal corresponding to the first flag generated by the on-die ECC circuit 350 to the pin, and the memory controller 100 may obtain the first flag based on the signal applied to the pin.

Alternatively, according to an example embodiment, the memory device 200 may extend the burst length. For example, the memory device 200 may select a single burst length from among a plurality of burst lengths and operate based on the selected burst length. Accordingly, the memory device 200 may expand the burst length by changing the burst length to a second burst length, which is relatively larger than the first burst length, during an operation based on the first burst length selected from among the plurality of burst lengths. The memory device 200 may provide the first flag, generated by the on-die ECC circuit 350, to the memory controller 100 using burst(s) added based on the extended burst length.

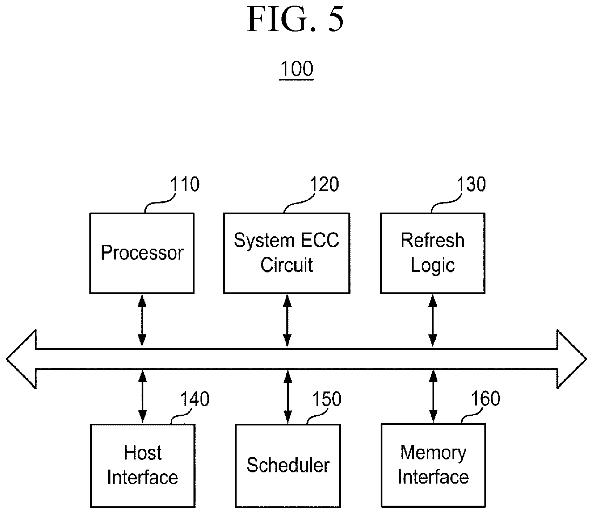

FIG. 5 is a block diagram of a memory controller according to an example embodiment. The memory controller 100 of FIG. 5 may correspond to, for example, the memory controller 100 of FIG. 1.

Referring to FIG. 5, the memory controller 100 may include a processor 110, a system ECC circuit 120, a refresh logic (i.e., refresh logic circuit) 130, a host interface 140, a scheduler (i.e., scheduler circuit) 150, and a memory interface 160, all of which are connected to each other via a bus.

The processor 110 may control the overall operation of the memory controller 100. For example, the processor 110 may control each of the system ECC circuit 120, the refresh logic 130, the host interface 140, the scheduler 150, and the memory interface 160.

The refresh logic 130 may generate a command to perform a normal refresh operation on the plurality of wordlines of the memory device 200. For example, the refresh logic 130 may generate an auto-refresh command for sequentially refreshing the plurality of wordlines depending on a refresh period.

The host interface 140 may interface with the host 15.

The scheduler 150 may manage the scheduling and transmission of sequences of commands generated within the memory controller 100.

The memory interface 160 may interface with the memory module 2000.

The system ECC circuit 120 may store a second data set in the parity memory device 200p. The second data set may include parity bits for a plurality of first data sets, respectively stored in the plurality of data memory devices 200d_1 to 200d_n. According to an example embodiment, one of the parity bits included in the second data set and the data bits corresponding to the parity bit may have different bit positions. To this end, the system ECC circuit 120 may map each of the data bits and a corresponding parity bit to have different bit positions. For example, the system ECC circuit 120 may map data bits, respectively selected from the plurality of first data sets, and corresponding parity bits to have different DQs (or DQ positions). Also, the system ECC circuit 120 may map data bits, respectively selected from of the plurality of first data sets, and corresponding parity bits to have different burst orders (or BL positions). Also, the system ECC circuit 120 may map data bits, respectively selected from the plurality of first data sets, and corresponding parity bits to have different BLs and DQ positions.

The system ECC circuit 120 may perform a system ECC operation based on the plurality of first data sets and the second data set obtained from the memory module 2000 through a read operation. The system ECC operation may include various operations for correcting errors included in one of the plurality of first data sets based on the second data set.

For example, when the plurality of first data sets and the second data set are received from the plurality of data memory devices 200d_1 to 200d_n and the parity memory device 200p, the system ECC circuit 120 may perform a parity check on the received data.

According to an example embodiment, the parity bits included in the second data set may be even XOR parities. The system ECC circuit 120 may compare a result of the XOR operation of data bits with the parity bit to perform a parity check. For example, when the result of the XOR operation matches the parity bit, it may be determined that the parity bit and the data bits mapped to the parity bit do not include error bits. When the result of the XOR operation does not match the parity bit, it may be determined that there is an error bit among the parity bit and the data bits mapped to the parity bit.

For example, the parity check may be performed to determine whether errors have occurred in the plurality of first data sets and the second data set. Also, the parity check may be performed to identify candidate error bit positions in each of the plurality of first data sets and the second data set.

However, even when the parity check is performed, it is not specified which of the plurality of first data sets and the second data set includes actual error bits. Therefore, the system ECC circuit 120 may specify an error data set including error bits by performing the following operations.

For example, when first flags corresponding to each of the plurality of first data sets and the second data set are obtained, the system ECC circuit 120 may determine an error data set including error bits, among the plurality of first data sets and the second data set, based on the obtained first flags.

According to an example embodiment, the system ECC circuit 120 may determine the error data set when the first flags have specific values. Also, according to an example embodiment, the system ECC circuit 120 may perform an additional iteration operation to determine the error data set, which will be described later, even when the first flags do not have the specific values. According to an example embodiment, the system ECC circuit 120 may include a parity check matrix used by the on-die ECC circuit 350 of the memory device 200, and may perform an iteration operation using the parity check matrix. Alternatively, according to an example embodiment, the system ECC circuit 120 may perform an iteration operation through the plurality of data memory devices 200d_1 to 200d_n and the parity memory device 200p. This will be described in detail later.

As described above, when the candidate error bit positions and the error data set are identified, the system ECC circuit 120 may perform an error correction operation by flipping bits corresponding to the candidate error bit positions among the bits included in the error data set.

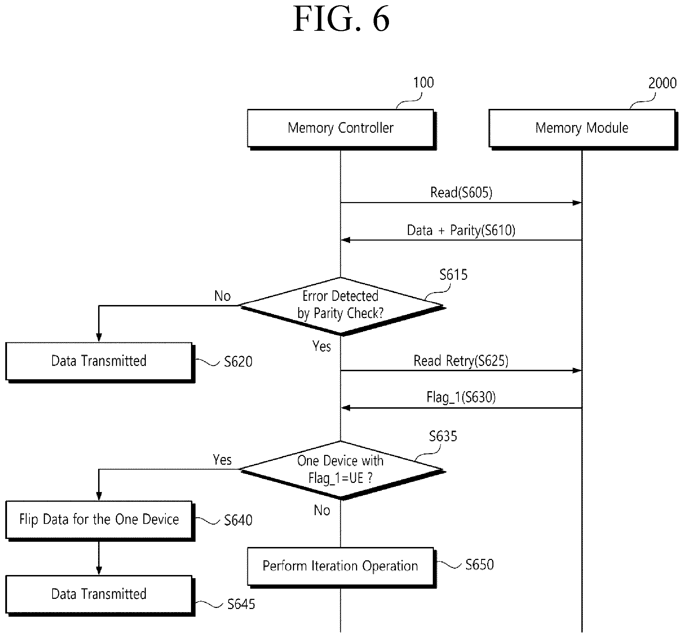

Hereinafter, the system ECC operations according to example embodiments will be described in detail with reference to FIGS. 6 to 11D.

FIG. 6 is a flowchart illustrating a method of operating a memory system according to an example embodiment. The memory controller 100 and the memory module 2000 of FIG. 6 may correspond to the memory controller 100 and the memory module 2000 included in the memory system 20 of FIG. 1, respectively. In FIG. 6, a plurality of data memory devices 200d_1 to 200d_n included in the memory module 2000 are storing the above-described plurality of first data sets, respectively. Also, the parity memory device 200p included in the memory module 2000 is storing the above-described second data set.

Referring to FIG. 6, in operation S605, the memory controller 100 may transmit a read command to the memory module 2000. The read command may be a normal read command, but example embodiments are not limited thereto. For example, when data is requested by a host 15, the memory controller 100 may transmit a read command to each of the plurality of data memory devices 200d_1 to 200d_n and the parity memory device 200p.

In operation S610, each of the plurality of data memory devices 200d_1 to 200d_n and the parity memory device 200p may perform a read operation in response to the read command and provide a plurality of first data sets Data and a second data set Parity to the memory controller 100.

In operation S615, the memory controller 100 may perform a parity check on the plurality of first data sets and the second data set. When no error is detected through the parity check in operation S615, the flow proceeds to operation S620 in which the memory controller 100 may transmit the plurality of first data sets to the host 15.

When candidate error bit positions are identified through the parity check in operation S615, the memory controller 100 may obtain first flags Flag_1, corresponding to each of the plurality of first data sets and the second data set, from the plurality of data memory devices 200d_1 to 200d_n and the parity memory device 200p, respectively. The first flag Flag_1 may indicate uncorrectable error (UE) or uncorrectable error (non-UE). However, example embodiments are not limited thereto, and the first flag Flag_1 may also include no error (NE) indicating that no error is detected, correctable error (CE) indicating that an error has been corrected, or uncorrectable error (UE). NE and CE may correspond to non-UE.

According to an example embodiment, in operation S625, the memory controller 100 may transmit a read retry command to the plurality of data memory devices 200d_1 to 200d_n and the parity memory device 200p. Accordingly, in operation S630, each of the plurality of data memory devices 200d_1 to 200d_n and the parity memory device 200p may provide the first flag Flag_1 to the memory controller 100 in response to the read retry command.

According to an example embodiment, each of the plurality of data memory devices 200d_1 to 200d_n and the parity memory device 200p may include the mode register described in FIG. 4. The memory controller 100 may change a set value of the mode register to a second value using a mode register write command. Then, the memory controller 100 may transmit a normal read command to each of the plurality of data memory devices 200d_1 to 200d_n and the parity memory device 200p to obtain the first flags Flag_1.

In operation S635, the memory controller 100 may attempt to identify an error data set based on the first flags Flag_1. For example, when only one of the first flags Flag_1 is UE, the memory controller 100 may identify a data set corresponding to the UE, among the plurality of first data sets and the second data set, as the error data set.

When an error data set is identified in operation S635, the flow proceeds to operation S640 in which the memory controller 100 may flip bits corresponding to candidate error bit positions among bits included in the error data set. Accordingly, errors that have occurred in one of the plurality of first data sets and the second data set may be corrected.

According to an example embodiment, one of the plurality of first data sets may be an error data set. In operation S645, the memory controller 100 may transmit the remaining first data sets, excluding the error data set, and an error data set, in which bits corresponding to the candidate error bit positions are flipped, to the host 15.

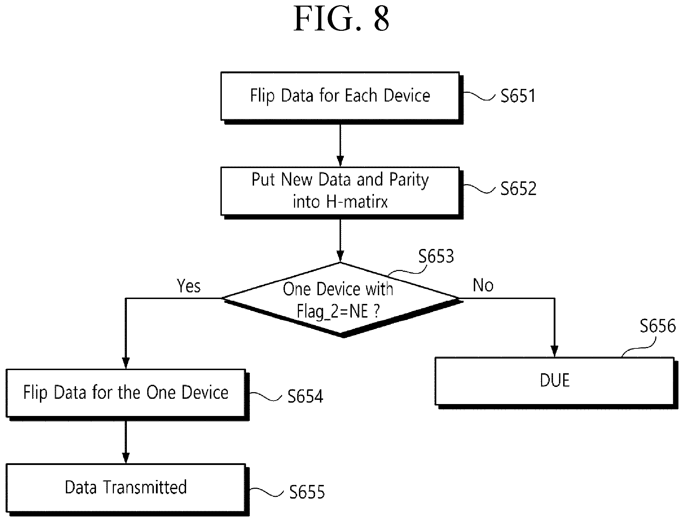

When only one of the first flags Flag_1 is not UE in operation S635, for example, when the error data set is not identified, the flow proceeds to operation S650 in which the memory controller 100 may perform an iteration operation. For example, when all of the first flags Flag_1 indicate non-UE in operation S635, the flow proceeds to operation S650 in which the memory controller 100 may perform an iteration operation. The iteration operation will be described in detail with reference to FIG. 8.

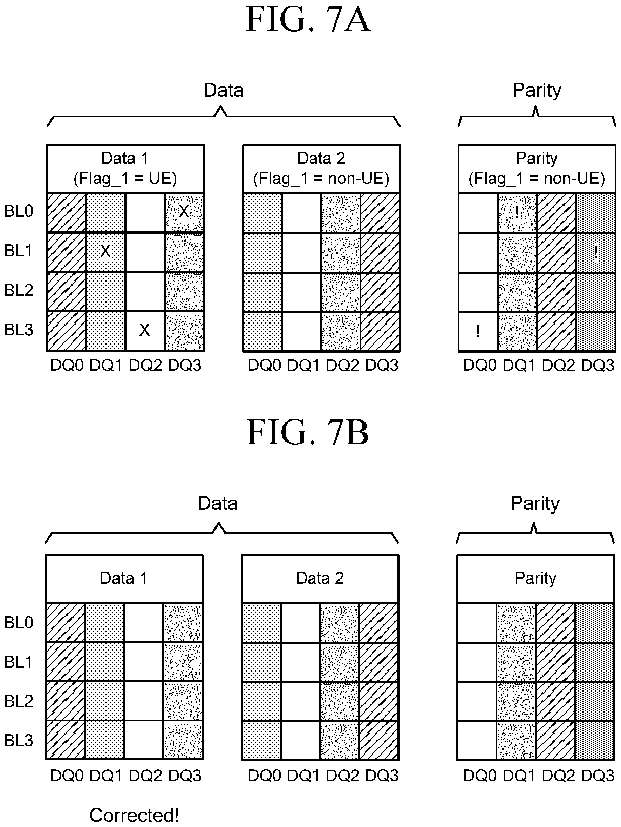

FIGS. 7A and 7B are diagrams illustrating a method of operating a memory system according to an example embodiment. FIG. 7A illustrates first data sets Data 1 and Data 2 stored in two data memory devices each having a prefetch size of 16 bits and a second data set parity stored in a parity memory device. FIG. 7B illustrates a state after an error correction operation of the memory system 20 is performed on the data sets of FIG. 7A.

FIGS. 7A and 7B illustrate an example in which each data bit and a corresponding parity bit are mapped to have different DQ positions, as illustrated in FIG. 2C. In FIGS. 7A and 7B, the operation of the memory system 20 will be described by way of an example in which three errors indicated by "X" occur in Data 1.

When Data 1, Data 2, and Parity as illustrated in FIG. 7A are received through a read operation, the memory controller 100 may perform a parity check on Data 1, Data 2, and Parity and identify candidate error bit positions.

Referring to FIG. 7A, errors are present in bit positions (BL0, DQ3), (BL1, DQ1), and (BL3, DQ2) among bit positions of Data 1. Therefore, the memory controller 100 may identify that errors have occurred in bit positions (BL0, DQ1), (BL1, DQ3), and (BL3, DQ0) (indicated by "!"), among the bit positions of Parity, through a parity check between the mapped data bits and parity bit.

Accordingly, the memory controller 100 may identify (BL0, DQ3) of Data 1 and (BL0, DQ2) of Data 2 mapped to (BL0, DQ1) of Parity, together with (BL0, DQ1) of Parity, as candidate error bit positions. Also, the memory controller 100 may identify (BL1, DQ1) of Data 1 and (BL1, DQ0) of Data 2 mapped to (BL1, DQ3) of Parity, together with (BL1, DQ3) of Parity, as candidate error bit positions. Also, the memory controller 100 may identify (BL3, DQ2) of Data 1 and (BL3, DQ1) of Data 2 mapped to (BL3, DQ0) of Parity, together with (BL3, DQ0) of Parity, as candidate error bit positions.

As a result, the memory controller 100 may identify the candidate error bit positions for Data 1 as (BL0, DQ3), (BL1, DQ1), and (BL3, DQ2), the candidate error bit positions for Data 2 as (BL0, DQ2), (BL1, DQ0), and (BL3, DQ1), and the candidate error bit positions for Parity as (BL0, DQ1), (BL1, DQ3), and (BL3, DQ0).

The candidate error bit positions have been identified, so that the memory controller 100 may obtain the first flags Flag_1 corresponding to Data 1, Data 2, and Parity.

In an example embodiment, the two data memory devices corresponding to Data 1 and Data 2 and the parity memory device corresponding to Parity may each include the on-die ECC circuit 350 using a single error correction, double error detection (SECDED) Hamming code. As shown in FIG. 7A, there are three bits of error in Data 1, and the on-die ECC circuit 350 of the data memory device corresponding to Data 1 may therefore generate UE as the first flag Flag_1. Also, there is no error in Data 2, so that the on-die ECC circuit 350 of the data memory device corresponding to Data 2 may generate non-UE as the first flag Flag_1. Also, there is no error in Parity, so that the on-die ECC circuit 350 of the parity memory device may generate non-UE as the first flag Flag_1.

According to an example embodiment, the memory controller 100 may obtain the first flag Flag_1 generated from each memory device using a read retry command or a mode register.

The memory controller 100 may attempt to identify the error data set based on the obtained first flags Flag_1. For example, when only one of the first flags Flag_1 is UE, the memory controller 100 may identify the data set corresponding to the UE as an error data set among the plurality of first data sets and the second data set. Referring to FIG. 7A, only the first flag Flag_1 corresponding to Data 1 is UE, so that the memory controller 100 may identify Data 1, a data set corresponding to UE, as an error data set.

Accordingly, the memory controller 100 may flip bits corresponding to the candidate error bit positions, among bits included in the error data set. In the example of FIG. 7A, the error data set is Data 1 and the candidate error bit positions for Data 1 are identified as (BL0, DQ3), (BL1, DQ1), and (BL3, DQ2). The memory controller 100 may therefore flip bits corresponding to (BL0, DQ3), (BL1, DQ1), and (BL3, DQ2) among the bits of Data 1. As a result, three error bits included in Data 1 may be corrected, as illustrated in FIG. 7B.

FIG. 8 is a flowchart illustrating a method of operating a memory system according to an example embodiment. The operations of FIG. 8 may be an example of the iteration operation in operation S650 of FIG. 6. As described above with reference to FIG. 6, according to an example embodiment, the memory controller 100 may perform an iteration operation when first flags Flag_1 are all non-UE.

Referring to FIG. 8, in operation S651, the memory controller 100 may flip bits corresponding to candidate error bit positions in each of a plurality of first data sets and a second data set. Accordingly, a plurality of third data sets, respectively corresponding to the plurality of first data sets, and a fourth data set corresponding to the second data set may be generated.

In operation S652, the memory controller 100 may perform an error correction operation on each of a plurality of third data sets and a fourth data set using a parity check matrix or (H-matrix), and may generate a second flag Flag_2 regarding the error correction operation performed for each of the plurality of third data sets and the fourth data set.

The second flag Flag_2 may indicate no error (NE) correctable error (CE), or uncorrectable error (UE). NE may indicate no error is detected. CE may indicate that an error has been corrected. UE may indicate that an uncorrectable error has occurred.

According to an example embodiment, the parity check matrix used by the memory controller 100 to generate the second flag Flag_2 may be the same as the parity check matrix used by an on-die ECC circuit 350 included in each of a plurality of memory devices 200p and 200d_1 to 200d_n.

In operation S653, the memory controller 100 may attempt to identify an error data set based on the second flags Flag_2. For example, when only one of the second flags Flag_2 corresponding to each of the plurality of third data sets and the fourth data set is NE, the memory controller 100 may identify a data set corresponding to NE, among the plurality of first data sets and the second data set, as an error data set. For example, the second flags Flag_2 correspond to the plurality of third data sets and the fourth data set but the plurality of third data sets respectively correspond to the plurality of first data sets and the fourth data set corresponds to the second data set, so that a data set corresponding to NE, among the plurality of first data sets and the second data sets, may be identified.

When the error data set is identified in operation S653, the flow proceeds to operation S654 in which the memory controller 100 may flip bits corresponding to candidate error bit positions, among bits included in the error data set. Accordingly, errors that have occurred in one of the plurality of first data sets and the second data set may be corrected.

According to an example embodiment, one of the plurality of first data sets may be an error data set. In operation S655, the memory controller 100 may transmit the remaining first data sets, excluding the error data set, and an error data set, in which the bits corresponding to the candidate error bit positions are flipped, to a host 15.

When only one of the second flags Flag_2 is not NE in operation S653, for example, when the error data set is not identified, the flow proceeds to operation S656 in which the memory controller 100 may determine that an error has been detected in the plurality of first data sets and the second data set, but that the error was uncorrectable. Such a situation may be referred to as detected but uncorrectable error (DUE), but example embodiments are not limited thereto. For example, when two or more of the second flags Flag_2 are NE in operation S653, the memory controller 100 may determine that DUE has occurred.

While an example has been provided in which the memory controller 100 performs the iteration operations in operations S651 to S656, example embodiments are not limited thereto.

For example, when the memory controller 100 does not identify an error data set in operation S635, the memory controller 100 may control the plurality of memory devices 200p and 200d_1 to 200d_n to flip the bits corresponding to the candidate error bit positions in each of the plurality of first data sets and the second data set, thereby generating a plurality of third data sets and a fourth data set.

Also, the memory controller 100 may control the plurality of memory devices 200p and 200d_1 to 200d_n to perform an error correction operation on each of the plurality of third data sets and the fourth data set, thereby generating second flags Flag_2. Each of the second flags Flag_2 may be generated by the on-die ECC circuit 350 included in each of the plurality of memory devices 200p and 200d_1 to 200d_n.

Also, the memory controller 100 may control the plurality of memory devices 200p and 200d_1 to 200d_n to transmit the generated second flag Flag_2.

Accordingly, the memory controller 100 may perform an iteration operation by performing operations S653 to S656 based on the obtained second flags Flag_2.

As described above, the memory system 20 may increase the likelihood of detecting an error data set through the iteration operation. Also, when an error data set is not identified, the memory system 20 may eliminate the likelihood of silent data corruption (SDC), in which data that should be corrected is not corrected while data that should not be corrected is corrected, by treating such a situation as DUE without performing further error correction operations.

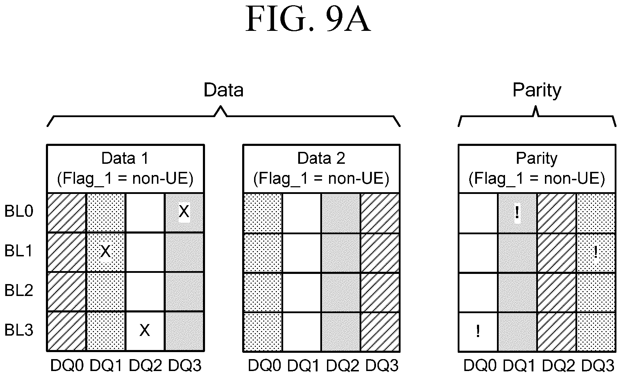

FIGS. 9A to 9D are diagrams illustrating a method of operating a memory system according to an example embodiment. FIG. 9A illustrates a situation in which an on-die ECC circuit 350 of a data memory device corresponding to Data 1 fails to detect errors in Data 1 in the same situation as FIG. 7A. In the FIG. 9A, three errors in Data 1 are indicated by "X" and bit positions of Parity identified by the memory controller 100 through a parity check between the mapped data bits and parity bit are indicated by "!". The on-die ECC circuit 350 is unable to detect 100% of errors included in a data set, so that such a situation may occur.

Regardless of the fact that the on-die ECC circuit 350 corresponding to Data 1 has failed to detect the error in Data 1, the memory controller 100 may identify candidate error bit positions through a parity check operation on Data 1, Data 2, and Parity (for example, operation S615 of FIG. 6). The candidate error bit positions are the same as those described in FIG. 7A.

Accordingly, the memory controller 100 may obtain the first flags Flag_1 from each memory device and attempt to identify the error data set based on the first flags Flag_1 (for example, operation S635 of FIG. 6).

However, all of the first flags Flag_1 obtained by the memory controller 100 from each memory device indicate non-UE as illustrated in FIG. 9A, so that the error data set may not be identified and the memory controller 100 may perform an iteration operation (for example, operation S650 of FIG. 6).

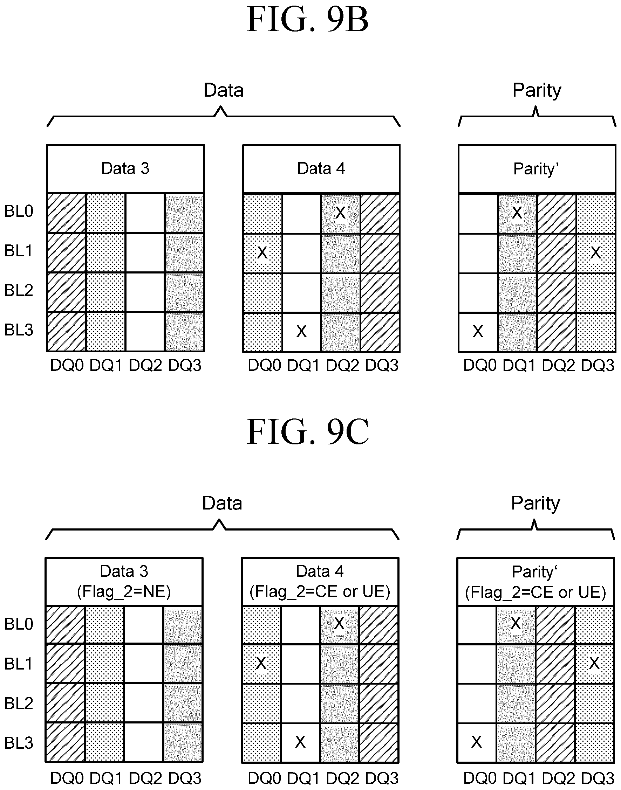

For example, the memory controller 100 may flip bits corresponding to candidate error bit positions in each of Data 1, Data 2, and Parity to generate new data sets Data 3, Data 4, Parity' as illustrated in FIG. 9B (for example, operation S651 of FIG. 8).

Referring to FIG. 9B, Data 3 may be generated by flipping the bits corresponding to the candidate error bit positions in Data 1, so that errors present in Data 1 are no longer present in Data 3. There were no errors in Data 2 and Parity, so that errors indicated by "X" may occur in Data 4 and Parity' generated by flipping the bits corresponding to the candidate error bit positions.

The memory controller 100 may perform an error correction operation on each of Data 3, Data 4, and Parity' using a parity check matrix, such as the parity check matrix used in the memory devices storing Data 1, Data 2, and Parity, and may generate second flags Flag_2 regarding the error correction operation (for example, operation S652 of FIG. 8).

FIG. 9C illustrates a second flags Flag_2 generated for each of Data 3, Data 4, and Parity'. Referring to FIG. 9C, there is no error in Data 3, so that the second flag Flag_2 for Data 3 may be NE. Also, there are errors in Data 4 and Parity' (indicated by "X"), so that the second flags Flag_2 for Data 4 and Parity' may be CE or UE.

The memory controller 100 may attempt to identify the error data set based on the second flags Flag_2 (for example, operation S653 of FIG. 8). For example, when only one of the second flags Flag_2 is NE, the memory controller 100 may identify the data set corresponding to NE, among Data 1, Data 2, and Parity, as the error data set. In the example of FIG. 9C, only the second flag Flag_2 corresponding to Data 3 is NE, so that the memory controller 100 may identify Data 1, corresponding to Data 3, as the error data set among Data 1, Data 2, and Parity.

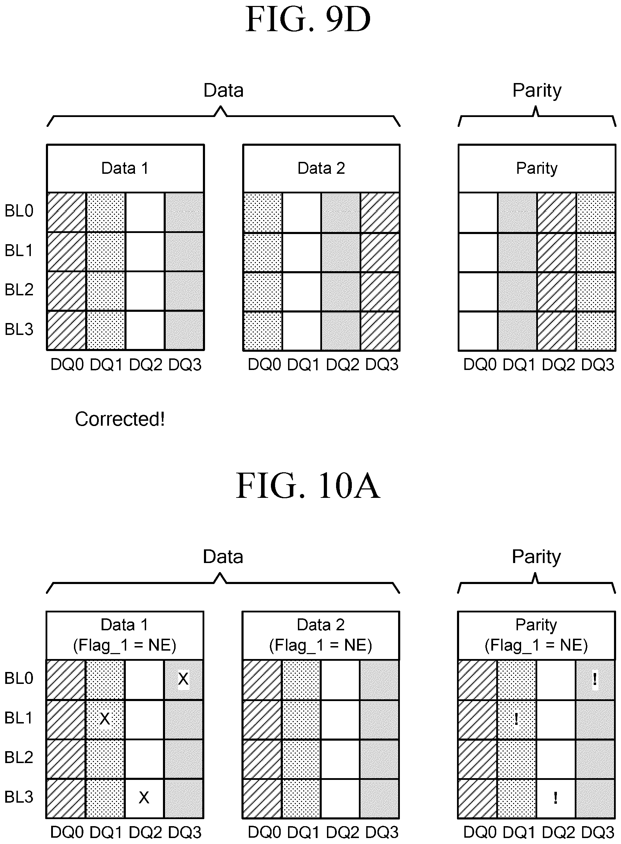

Accordingly, the memory controller 100 may flip the bits corresponding to the candidate error bit positions, among the bits included in the error data set. In the example of FIG. 9A, the error data set is Data 1 and the candidate error bit positions for Data 1 are identified as (BL0, DQ3), (BL1, DQ1), and (BL3, DQ2), so that the memory controller 100 may flip bits corresponding to (BL0, DQ3), (BL1, DQ1), and (BL3, DQ2) in Data 1, among the bits of Data 1. As a result, the three error bits included in Data 1 may be corrected, as illustrated in FIG. 9D.

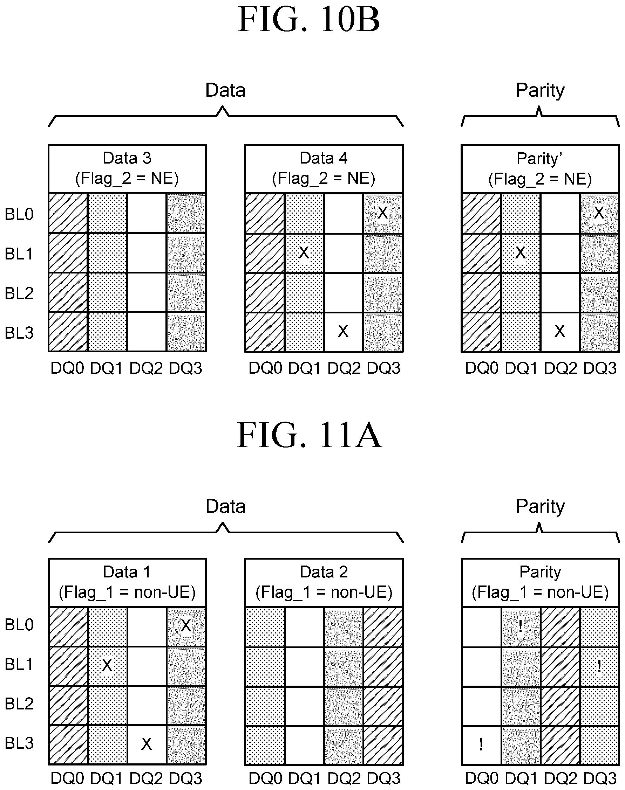

FIGS. 10A and 10B are diagrams illustrating limitations of an error correction operation during related parity mapping. Referring to FIGS. 10A and 10B, in the case of a related technique, a parity bit for data bits having the same bit position in a first data set Data 1 and another first data set Data 2 may be stored in the same bit position of a second data set Parity.

FIG. 10A illustrates a situation in which errors occur in Data 1 as illustrated in FIG. 9A, but the on-die ECC circuit 350 of the data memory device corresponding to Data 1 fails to detect the errors and generates the first flag Flag_1 as NE. There are no errors in Data 2 and Parity, so that the corresponding on-die ECC circuits 350 may also generate the first flag Flag_1 as NE. In the FIG. 10A, three errors in Data 1 are indicated by "X" and bit positions of Parity identified through a parity check between the mapped data bits and parity bit are indicated by "!".

The first flags Flag_1 are all NE or non-UE, so that the candidate error bit positions may be identified through a parity check operation on Data 1, Data 2, and Parity, while the error data set is not identifiable.

In the case of a related technique, by flipping the bits corresponding to the candidate error bit positions among the bits included in Data 1, Data 2, and Parity, new data sets Data 3, Data 4, and Parity' are generated, as illustrated in FIG. 10B. Referring to FIG. 10B, Data 3 may be generated by flipping the bits corresponding to the candidate error bit positions in Data 1, so that errors present in Data 1 are no longer present in Data 3. There were no errors in Data 2 and Parity, so that errors indicated by "X" may occur in Data 4 and Parity' generated by flipping the bits corresponding to the candidate error bit positions. However, in the case of a related technique, even if the second flags Flag_2 are obtained for each of Data 3, Data 4, and Parity', the error data set is not identifiable.

For example, the on-die ECC circuit 350 of the data memory device corresponding to Data 1, the on-die ECC circuit 350 of the data memory device corresponding to Data 2, and the on-die ECC circuit 350 of the parity memory device may be the same product. For example, the on-die ECC circuit 350 of the data memory device corresponding to Data 1 failed to detect the errors in (BL0, DQ3), (BL1, DQ1), and (BL3, DQ2), which means that the on-die ECC circuits 350 of other memory devices also fail to detect errors occurring in (BL0, DQ3), (BL1, DQ1), and (BL3, DQ2).

Accordingly, even when the second flags Flag_2 are obtained using Data 3, Data 4, and Parity' as illustrated in FIG. 10B, the second flags Flag_2 all become NE and the error data set is no longer identifiable.

In example embodiments, parity mapping is performed to have different bit positions, so that even when the same on-die ECC circuit 350 or the same parity check matrix is used, an additional error data set may be detected through an iteration operation.

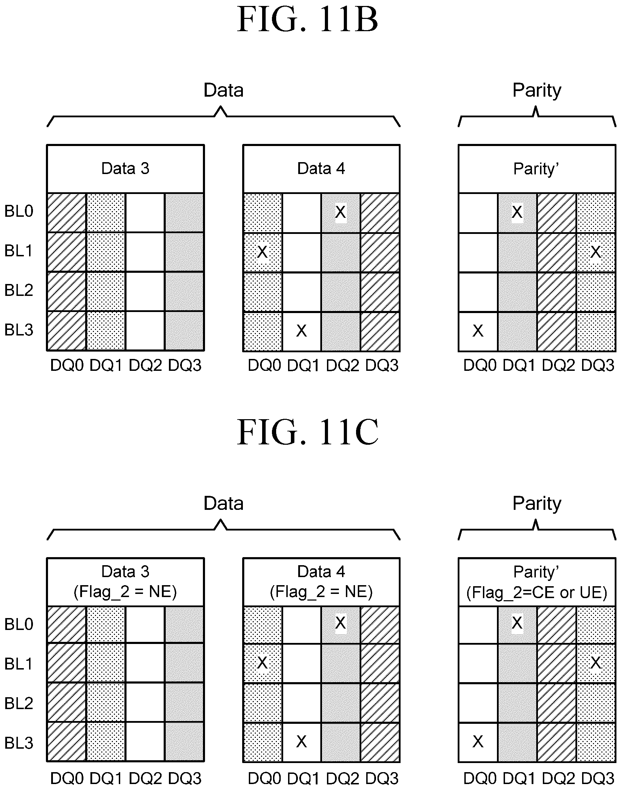

FIGS. 11A to 11D are diagrams illustrating a method of operating a memory system according to an example embodiment. Errors in data are indicated by "X" and bit positions of Parity identified through a parity check between the mapped data bits and parity bit are indicated by "!". FIGS. 11A and 11B illustrate the same situations as illustrated in FIGS. 9A and 9B, respectively. Therefore, the duplicate descriptions are omitted to avoid redundancy.

After the iteration operation is started and new data sets Data 3, Data 4, Parity' are generated, the memory controller 100 may generate second flags Flag_2 for Data 3, Data 4, and Parity'.

FIG. 11C illustrates a second flag Flag_2 generated for each of Data 3, Data 4, and Parity'. Referring to FIG. 11C, there is no error in Data 3, so that the second flag Flag_2 for Data 3 may be NE.

There are errors in Data 4 and Parity', so that the second flags Flag_2 for Data 4 and Parity' may be CE or UE, as described above. However, as described above, the likelihood of the on-die ECC circuit 350 detecting an error is not 100%, which means that the second flag for at least one of Data 4 and Parity' may be NE. FIG. 11C illustrates a case in which the second flag Flag_2 for Data 4 is NE.

When the second flag Flag_2 for Data 4 is NE, and Data 2 is also identified as an error data set, flipping candidate error bit positions for Data 2 may result in silent data corruption (SDC) in which data that should not be corrected is erroneously corrected. Accordingly, according to an example embodiment, when two or more of the second flags Flag_2 are NE, the memory controller 100 may determine that an error has been detected but is not correctable for the plurality of first data sets and the second data set. The operation of correcting data that should not be corrected is not performed, so that SDC may not occur.

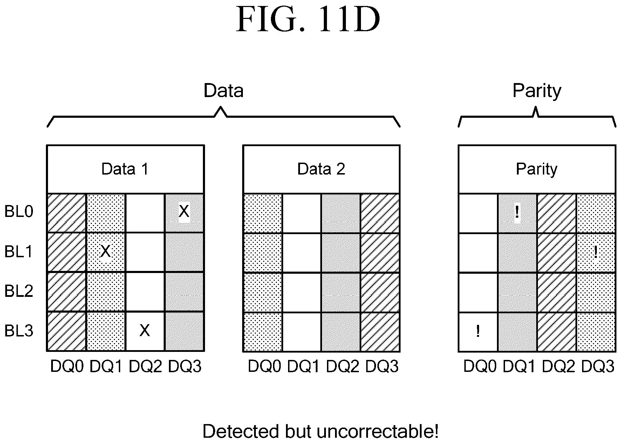

For example, referring to the example of FIG. 11C, the second flags Flag_2 for both Data 3 and Data 4 are NE, indicating that the memory controller 100 may interpret the situation as an error being detected but uncorrectable for Data 1, Data 2, and Parity. As illustrated in FIG. 11D, the error correction operation may no longer be performed for Data 1, Data 2, and Parity.

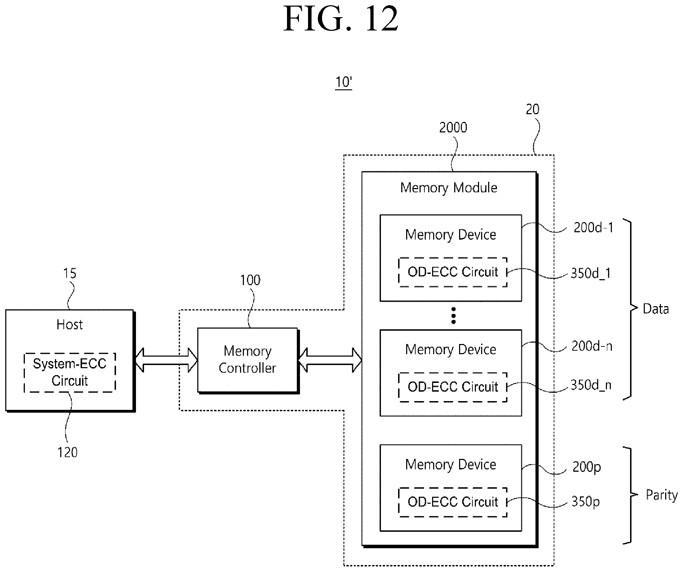

FIG. 12 is a block diagram of an electronic system according to an example embodiment. While a description has been provided for an example in which the system ECC circuit 120 is included in the memory controller 100, example embodiments are not limited thereto. For example, the system ECC circuit 120 performing the above-described system ECC operations may be implemented independently of the memory controller 100.

Referring to FIG. 12, an electronic system 10' may have the same configuration as the electronic system 10 of FIG. 1, except that the system ECC circuit 120 is included in a host 15 and external to the memory controller 100. Therefore, redundant descriptions are omitted. Various system ECC operations, except for data exchange with the memory module 2000 performed by the above-described memory controller 100, may be performed by the system ECC circuit 120 included in the host 15.

A technology for correcting all errors for a single data chip among data chips constituting a cache line size is referred to as chipkill or single device data correction (SDDC). Generally, two parity memory chips per cache line size are required for implementation of chipkill technique. However, according to various example embodiments, a high-performance chipkill technique may be implemented using a single system ECC chip.

## Claims

1. A memory system (20) comprising:
a plurality of first memory devices (200d_1-200d_n);
a second memory device (200p); and
a memory controller (100) configured to control the plurality of first memory devices (200d_1-200d_n) and the second memory device (200p),
wherein each of the plurality of first memory devices (200d_1-200d_n) is configured to store a first data set (Data 1) comprising a first set of data bits in different bit positions, each of the bit positions corresponding to a burst order (BL0-BL3) and a DQ (DQ0-DQ3),
wherein the second memory device (200p) is configured to store a second data set (Parity) comprising parity bits for a plurality of first data sets (Data 1, Data 2), respectively stored in the plurality of first memory devices (200d_1-200d_n), and
wherein a second set of data bits corresponding to a first parity bit of the parity bits are included in the plurality of first data sets (Data 1, Data 2), respectively, and at least two data bits of the second set of data bits have different bit positions.

2. The memory system (20) of claim 1, wherein the first parity bit has a value based on an exclusive OR, XOR, operation performed on the second set of data bits.

3. The memory system (20) of claim 1 or 2, wherein the at least two data bits have different burst orders (BL0-BL3) or different DQs (DQ0-DQ3) within corresponding at least two first data sets.

4. The memory system (20) of any one of claims 1 to 3, wherein each of the plurality of first memory devices (200d_1-200d_n) and the second memory device (200p) is further configured to perform a first error correction operation on a data sets input or output through a corresponding memory device using a parity check matrix, and generate a first flag regarding a result of the first error correction operation, and
wherein the memory controller (100) is further configured to perform a parity check on the plurality of first data sets (Data 1, Data 2) and the second data set (Parity) received from the plurality of first memory devices (200d_1-200d_n) and the second memory device (200p), and obtain the first flag from the plurality of first memory devices (200d_1-200d_n) and the second memory device (200p) to obtain first flags based on candidate error bit positions for each of the plurality of first data sets (Data 1, Data 2) and the second data set (Parity) being identified through the parity check.

5. The memory system (20) of claim 4, wherein the memory controller (100) is further configured to transmit the plurality of first data sets (Data 1, Data 2) to a host (15) based on the candidate error bit positions not being identified through the parity check.

6. The memory system (20) of claim 4 or 5, wherein the memory controller (100) is further configured to obtain the first flags based on a new read command or based on a setting value in a mode register included in each of the plurality of first memory devices (200d_1-200d_n) and the second memory device (200p),
wherein each of the plurality of first memory devices (200d_1-200d_n) and the second memory device (200p) is configured to provide, based on the new read command, the first flag regarding the result of the first error correction operation and a corresponding data set, and
wherein each of the plurality of first memory devices (200d_1-200d_n) and the second memory device (200p) is configured to selectively operate, based on the setting value, in a first mode, in which only the corresponding data set is provided based on a normal read command, and a second mode in which both the first flag regarding the result of the first error correction operation and the corresponding data set are provided based on the normal read command.

7. The memory system (20) of any one of claims 4 to 6, wherein each of the plurality of first memory devices (200d_1-200d_n) and the second memory device (200p) is further configured to provide the first flag to the memory controller (100) through a pin assigned to the first flag or by using an extended burst length.

8. The memory system (20) of any one of claims 4 to 7, wherein the first flag indicates non-uncorrectable error, Non-UE, based on determining there is no error or that the error has been corrected, and uncorrectable error, UE, based on determining an uncorrectable error has occurred, and
wherein the memory controller (100) is further configured to identify an error data set corresponding to the first flag indicating the UE, among the plurality of first data sets (Data 1, Data 2) and the second data set (Parity), based on only one of the first flags indicating the UE, and flip bits corresponding to the candidate error bit positions included in the identified error data set to generate a flipped error data set.

9. The memory system (20) of claim 8, wherein the memory controller (100) is further configured to, based on the error data set being included in the plurality of first data sets (Data 1, Data 2), transmit remaining first data sets (Data 1, Data 2), excluding the error data set, and the flipped error data set to a host (15).

10. The memory system (20) of any one of claims 4 to 9, wherein the memory controller (100) is further configured to:
generate a plurality of third data sets, respectively corresponding to the plurality of first data sets (Data 1, Data 2), and a fourth data set corresponding to the second data set (Parity), by flipping bits corresponding to the candidate error bit positions among bits included in each of the plurality of first data sets (Data 1, Data 2) and the second data set (Parity), based on all of the first flags indicating non-UE; and
perform a second error correction operation on each of the plurality of third data sets and the fourth data set using the parity check matrix and generate a second flag indicating a result of the second error correction operation for each of the plurality of third data sets and the fourth data set.

11. The memory system (20) of claim 10, wherein the second flag indicates no error, NE, based on determining there is no error, correctable error, CE, based on determining the error has been corrected, and uncorrectable error, UE, based on determining the uncorrectable error has occurred, and
wherein the memory controller (100) is further configured to:
identify an error data set corresponding to the NE among the plurality of first data sets (Data 1, Data 2) and the second data set (Parity) based on only one of second flags, respectively corresponding to the plurality of third data sets and the fourth data set, indicating the NE; and
flip bits corresponding to the candidate error bit positions among bits included in the identified error data set to generate a flipped error data set.

12. The memory system (20) of claim 11, wherein the memory controller (100) is further configured to, based on the error data set being included in the plurality of first data sets (Data 1, Data 2), transmit remaining first data sets (Data 1, Data 2), excluding the error data set, and the flipped error data set to a host (15).

13. The memory system (20) of claim 11 or 12, wherein the memory controller (100) is further configured to determine errors were detected but uncorrectable for the plurality of first data sets (Data 1, Data 2) and the second data set (Parity), based on two or more of the second flags indicating the NE.

14. A method of operating a memory controller (100) to control a memory module (2000) including a plurality of first memory devices (200d_1-200d_n) and a second memory device (200p), the method comprising:
storing a plurality of first data sets (Data 1, Data 2) in the plurality of first memory devices (200d_1-200d_n), respectively; and
storing a second data set (Parity), comprising parity bits for the plurality of first data sets (Data 1, Data 2), in the second memory device (200p),
wherein each of the plurality of first data sets (Data 1, Data 2) comprises a first set of data bits having bit positions, each of the bit positions corresponding to a burst order (BL0-BL3) and a DQ (DQ0-DQ3), and
wherein a second set of data bits corresponding to a first parity bit of the parity bits are included in the plurality of first data sets (Data 1, Data 2), respectively, and bit positions of at least two data bits of the second set of data bits are different from each other.

15. The method of claim 14, comprising:
receiving the plurality of first data sets (Data 1, Data 2) and the second data set (Parity) from the plurality of first memory devices (200d_1-200d_n) and the second memory device (200p);
performing a parity check on the plurality of first data sets (Data 1, Data 2) and the second data set (Parity) to identify candidate error bit positions for each of the plurality of first data sets (Data 1, Data 2) and the second data set (Parity);
obtaining first flags regarding results of error correction operations, performed on each of the plurality of first data sets (Data 1, Data 2) and the second data set (Parity), by receiving a first flag from each of the plurality of first memory devices (200d_1-200d_n) and the second memory device (200p); and
identifying a data set comprising error bits, among the plurality of first data sets (Data 1, Data 2) and the second data set (Parity), based on the first flags.
